Europäisches Patentamt

European Patent Office

Office européen des brevets

(11) Publication number: **0 287 793**
**A2**

# EUROPEAN PATENT APPLICATION

(21) Application number: 88103611.5

(51) Int. Cl.⁴: **H01L 21/00 , H01L 21/84**

(22) Date of filing: 08.03.88

(30) Priority: 23.04.87 US 41575

(43) Date of publication of application:
26.10.88 Bulletin 88/43

(84) Designated Contracting States:
DE FR GB IT

(71) Applicant: **International Business Machines Corporation**
**Old Orchard Road**
**Armonk, N.Y. 10504(US)**

(72) Inventor: **Kirchner, Peter D.**
**RR1, Box 281**
**Garrison N.Y. 10524(US)**
Inventor: **Warren, Alan C.**
**150 Overlook Ave, Apt. 7A**
**Peekskill N.Y. 10566(US)**
Inventor: **Woodall, Jerry M.**
**336 Cherry Street**
**Bedford Hills N.Y. 10507(US)**

(74) Representative: **Gaugel, Heinz, Dipl.-Ing.**
**IBM Deutschland GmbH Schönaicher Strasse 220**
**D-7030 Böblingen(DE)**

(54) Integrated circuit substrate product.

(57) An integrated circuit substrate product comprising in combination:

a member having an essentially planar surface area (15), said member having a supporting region (1), and serially respectively between said supporting region (1) and said surface (15), a layer (2) of device quality monocrystalline material of a semiconductor having erosion termination capability (8) and being epitaxial with said supporting region (1), a stop layer (11) of a monocrystalline material capable of terminating at least an erosion operation to which said semiconductor is responsive epitaxial with said device layer (2), and an epitaxial regrowth enabling layer (9) of said semiconductor material epitaxial with said device layer (2) and including an epitaxial stop layer (14).

# FIG. 1

0 287 793

## INTEGRATED CIRCUIT SUBSTRATE PRODUCT

The technical field of the invention is the formation of very small dimension semiconductor integrated circuit structures in compound-type semiconductor materials. The more well-known of the compound semiconductor materials are composed of elements from Group III and Group V of the periodic table such as gallium arsenide.

Indirect dimensioning techniques are generally employed to produce submicron dimension type devices. One example of this type of technology is U.S. Patent 4,587,709 involving angular evaporation and etching, and another example is U.S. Patent 4,532,698 involving angular deposition and ion implantation.

In the semiconductor crystal itself, the problems associated with lateral pattern definition generally limits integrated circuit fabrication to one active region vertically within the semiconductor crystal for devices and one level of wiring with subsequent wiring levels being positioned above. An illustration of a structure where features are placed above the crystal surface is provided in U.S. Patent 4,166,223.

In copending application Serial No. 07/012,463, inventors E. Fossum, P.D. Kirchner, G.D. Pettit, A.C. Warren and J.M. Woodall, filed February 9, 1987, the fabrication of compound semiconductors using localized vapor chemical erosion is described and incorporated herein by reference. The capability described in that concurrent application permits regrowth in the same environment and facilitates some fabrication aspects useful in this invention.

Fig. 1 is a cross-sectional schematic view of the multilayer integrated circuit intermediate manufacturing product of the invention.

Fig. 2 is a schematic illustration of intersecting surfaces occurring in integrated circuits.

Fig. 3 is a schematic illustration of the exposure of lateral device interfaces in the structure of Fig. 1.

Fig. 4 is a schematic illustration of regrown and isolation regions employing the structure of Fig. 1.

Figs. 5-7 are intermediate fabrication structures illustrating planar patterned device elements in a substrate.

Figs. 8 and 9 are intermediate fabrication and completed structures illustrating self-aligned field effect transistor employing the invention.

The invention is a semiconductor intermediate manufacturing structure for integrated circuits having in a compound semiconductor crystal body stacked, support, device and patterning regions each with built-in processing facilitating capability.

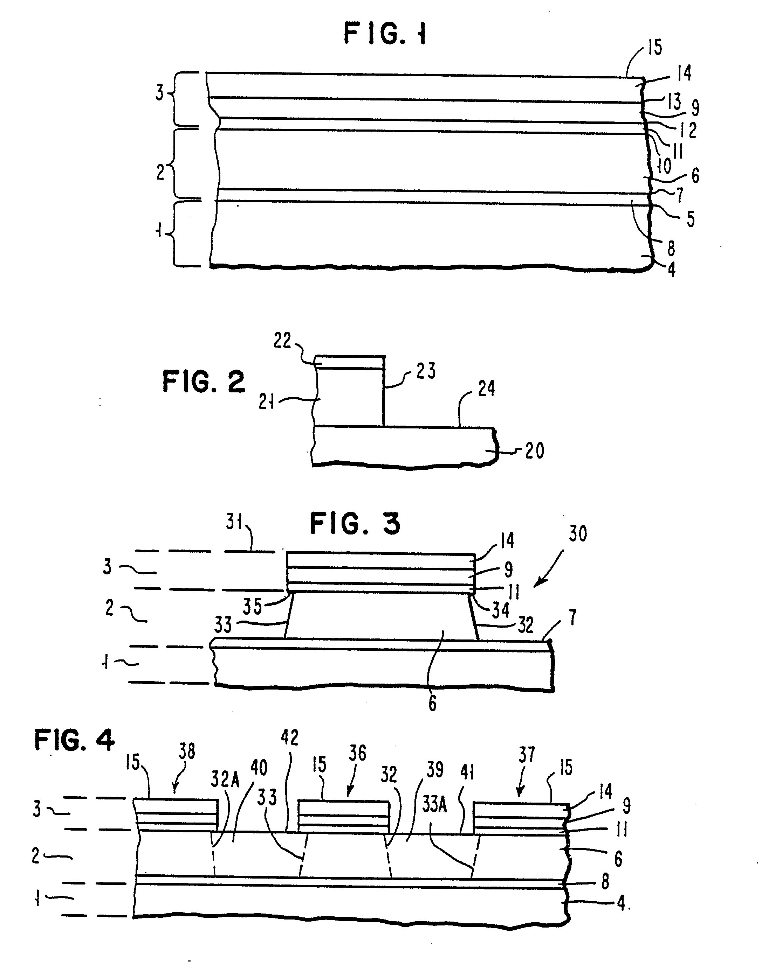

Referring to Fig. 1, the structure has three types of regions that are usable in combinations. There is a support and isolation region 1, having physical strength and high resistivity as desired, at least one device type region 2 of device quality monocrystalline semiconductor material having a thickness suitable for active semiconductor devices such as transistors, and having a vertical eroding processing termination capability and at least one patterning type region 3 generally not as thick as the region 2, also of device quality semiconductor material, and having a vertical material removal processing stop capability on the side adjacent region 2 and a regrowth control capability on the side opposite to region 2 which in the illustration of Fig. 1 is the surface.

The three types of regions in stacked combinations operate to facilitate fabrication of three dimensional integrated circuit devices where the region 1 provides the role of supporting substrate and isolation, the region 2 provides the device role and the region 3 provides the combined roles of masking and interconnecting. The regions 2 and 3 may be repeated in a stack as often as needed for the particular structure being fabricated.

The region 1 is usually of crystalline material 4, such as semi-insulating GaAs or sapphire having at a surface 5 an atomic spacing compatible with device quality semiconductor material. The standard technique in the art of an intermediate lattice accommodation layer may be used if needed.

The region 2 is made up of a device quality monocrystalline compound semiconductor material layer 6, such as GaAs, accompanied by a means that is a physical or compositional property of the semiconductor material of layer 6 that provides a capability of terminating an eroding processing operation performed on layer 6 at a known location. The eroding termination capability means may be as simple as making the layer thick enough to have sufficient material to accommodate standard time based etching tolerances which are generally larger than is acceptable for densely packed or high speed structures. The eroding termination capability means may further be, if desired, a crystallographic property. Since erosion operations generally progress more rapidly along particular crystallographic planes, proper selection of the crystallographic orientation of the layer 6 can produce V groove eroded surfaces where the erosion stops at the selected depth when the crystallographic planes of the slower erosion intersect.

For purposes of illustration, a preferred eroding termination means is a simple layer with a property that

2

stops the erosion. In Fig. 1, at an interface 7, this vertical eroding termination capability is shown as a layer 8 between the layers 6 and 4. The vertical eroding termination capability is achieved by imparting to the layer 8 a higher atomic binding energy and can also be used to help crystal lattice accommodation between the material of layers 4 and 6. The material GaAlAs is suitable for layer 8 when layers 4 and 6 are GaAs and can easily be provided by merely adding Al in growth.

The region 3 is made up of a device quality semiconductor layer 9, such as GaAs, positioned on the interface 10 of layer 6. Layer 9 is thinner than the layer 6 to permit ease of removal in patterning with an eroding stop layer 11 such as GaAlAs at an interface 12 with layer 6. The layer 11 is positioned between the layers 9 and 6. On an interface 13 with layer 9, there is positioned a regrowth inhibiting surface layer 14 of a material such as $SiO_2$ with an exposed surface 15.

Under some structural situations, it may be desirable to use a different set of conditions in patterning the region 3 from those employed in building and separating devices in the device region 6. The different conditions may be a different process for removal down to interface 12 than is used for removal down to interface 7 or through the use of a different material for layers 11 and 8. For purposes of explanation, the terminology removal will be used for operations from surface 15 through layer 11 and erosion for operations through layer 6 to layer 8.

In accordance with the invention by repetitive construction using layers of the types of 1, 2 and 3 together with patterned selective treatment of the device type layer, or layers, 2 and mask type layer, or layers, 3 different interwired integrated circuit results can be achieved.

The structure of the invention has mask layer capability and device layer capability, each with an epitaxial growth or etch compatible stop layer which defines an etch boundary, yet does it so that an interface for further epitaxial structure is provided serviceable for epitaxial regrowth in an unbroken environment insuring contamination and damage-free interfaces.

In submicron dimension type structures all the techniques currently employed produce some detrimental effects. The heterostructure substrate of the invention accompanied by localized vapor chemical erosion which in turn is followed by regrowth as desired in the same environment as described in patent application Serial No. 07/012,463 filed February 9, 1987, provides the most favorable performance seen heretofore.

The intermediate manufacturing product heterostructure substrate of Fig. 1 facilitates the basic requirements of integrated circuit technology in that isolated devices can be fabricated and interconnected as desired, and it facilitates in such a manner that critical submicron dimensions are achievable with highly controllable damage and residue free techniques.

Referring next to Fig. 2, a schematic illustration is provided of the intersecting surfaces occurring in integrated circuits. In Fig. 2, on a substrate 20, a layer 21 of device quality semiconductor material has been protected by a patterned mask 22 and an interface 23 is established by removing material to the interface 24. In integrated circuit technology, as device dimensions reach submicron levels, the positioning of the mask 22, the location and quality in damage and residue of both the interfaces 23 and 24 require greater precision, and upon completion of active devices, subsequent interconnection after removal of mask 22 requires delicate dimensional precision to retain the facility for handling low signals.

Referring next to Fig. 3, a schematic view is provided illustrating the use of the invention in connection with the type of situation in integrated device fabrication of Fig. 2. In Fig. 3 material has been removed from the device 2 and patterning 3 regions down to the interface 7 at layer 8 by providing openings or windows 30 and 31 in patterning region 3 using a removal operation that penetrates all layers 6, 9, 11 and 14, so that interfaces 32 and 33 of the device layer 6 are exposed.

Depending on the type of removal operation employed where the layer is thicker, such as layer 6, there may be some lateral removal or undercutting illustrated as elements 34 and 35. When the removal technique is vapor chemical erosion as described in copending application serial number 07/012,463 filed February 9, 1987, the undercutting follows crystallographic planes and is precisely controllable.

It will be apparent that the vertical location of interface 7 with respect to the surface 15 and the horizontal location of interfaces 32 and 33 in any future device body made in layer 6, in accordance with the invention, have been established by the nature of the responsiveness of the materials to removal operations and the location of the built-in stops in the structure of Fig. 1.

Referring to Fig. 4, a schematic illustration is provided of the type of structure of Fig. 3 with isolation on both sides. The structure of Fig. 4 has a device region 36 in the center following the structure of Fig. 3 with isolation regions 37 and 38 at each side. The structure in Fig. 4 is shown after a first erosion patterning step. The material is eroded from the region 3 between the device area 36 of the isolation areas 37 and 38 down to the region 2. The region 2 is eroded between the interfaces 32 and 33 and 32A and 33A down to the stop layer 8 using as an example the technique of vapor chemical erosion described in patent application serial number 07/012,463 filed February 9, 1987. The regions 39 and 40 are then regrown epitaxially at least to the lines 41 and 42 and in the epitaxial growth of regions 39 and 40 appropriate conductivity type and resistivity may be imparted.

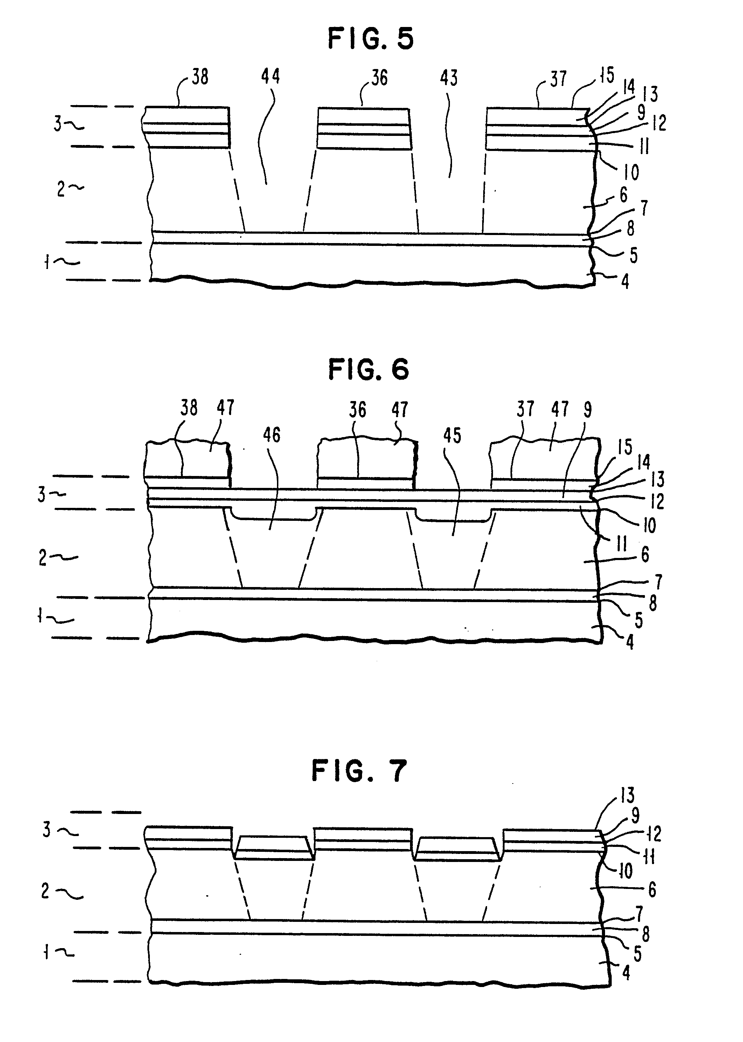

Referring next to Figs. 5-7, these are intermediate structures illustrating the fabrication steps in providing a planar patterned substrate. In Fig. 5, there is shown an intermediate structure of the type in Fig. 4 wherein there is a central device area 36 having on each side an isolation type area 37 and 38. The structure has in the region 1 a substrate 4 and in the region 2 beginning at the substrate an erosion stop layer followed by a device layer 6 and in the region 3 adjacent the device layer 6 is a removal stop layer 11, a device quality connecting layer 9 and a mask layer 14. The region 3 may be considered to be a multi-functioned patterning mask device in which the layer 11 is a built-in stop layer for the removal of the layers above it. The layer 9 is an epitaxial regrowth enabling layer for interconnections and the layer 14 inhibits epitaxial regrowth. In accordance with the invention, the layer 11 would have epitaxial compatibility with the layer 6 at the interface 10 and in addition would have a higher binding energy so that removal operations in the regions 43 and 44 could be conducted down to the interface 12 with the layer 11 if so desired.

The illustration in Fig. 5 shows the erosion in regions 43 and 44 as having proceeded all the way down to the erosion stop layer 8 completely through the device layer 6.

In accordance with the invention, this is accomplished by a removal step in regions 43 and 44 which proceeds through layers 14, 9 and 11, followed by an erosion operation which progresses through the layer 6 but is stopped at layer 8. The difference between the removal operation and the erosion operation are that the removal operation is capable of proceeding through the layer 11 whereas the erosion operation where the layer 11 and the layer 8 are of the same material is such that it is stopped by layer 11 or layer 8, whichever the erosion operation encounters first.

Generally the removal step involves a straight chemical etch whereas the erosion step will involve the technique of vapor chemical erosion described in Serial No. 07/012,463 filed February 9, 1987.

The structure of the invention is such that the operations of removal, erosion, regrowth and removal of material from surfaces on which it doesn't grow epitaxially, termed debris, can take place and in Table 1, there is a listing of the condition at the surface and the type of resulting situation when the steps of removal, erosion, regrowth and debris removal take place.

## Table 1

| Condition | Result After Removal, Erosion, Regrowth & Debris Removal |
|---|---|
| A. Surface 15 of layer 14 exposed | Interface 13 of layer 9 exposed. |
| B. Layer 14 removed-interface 13 of layer 9 exposed | Erosion removes layer 9. Epitaxial regrowth onto layer 11. |
| C. Layers 11, 9 and 14 removed-interface 10 of layer 6 exposed | Erosion removes layer 6-stops at layer 8. Regrowth on layer 8 and on the faces of layer 6 exposed by the erosion. |

Referring next to Fig. 6, wherein the material of layer 6 has been epitaxially regrown in the openings 43 and 44 of Fig. 5 forming therein semiconductor material for particular conductivity type since doping is appropriately included in the regrown material to match doping already included in the layer 6 forming the regions 45 and 46.

As the growth continues in the region of the layer 11, the ingredients in the regrowth are changed to match the layer 11 so that the layer 11 is now continued across the surface of the regions 45 and 46 with some added thickness and similarly with again a change of ingredients in the environment. The layer 9 is grown on the regrown layer 11. The regrowth on the regions still covered by the layer 14 results in general debris 47. Thus, the result of a regrowth permits the insertion of epitaxial inclusions in the substrate which are laterally separated from device and isolation regions and which present to the surface a surface for further epitaxial growth, such as another substrate, if that were to be the type of structure desired.

Referring next to Fig. 7, which is Fig. 6 with the debris 47 and the mask layer 14 removed, thereby providing a planar patterned substrate for further growth of connections, wiring and further substrates.

What has been described thus far, in accordance with the invention, a substrate is provided that contains a support layer, a device layer with an erosion termination capability and a plurality of layers in the form of a multi-functional masking and interconnection capability in which there is a stop layer for a removal operation, a layer of material capable of regrowth of device quality material and a growth inhibiting masking layer. The substrate is usable with a variety of operations to provide prepatterned inclusions in a substrate for further growth operations.

The preferred embodiment of the structure of the invention would be a substrate having devices of InGaAs channel FETs in which the erosion operation is performed by vapor chemical erosion.

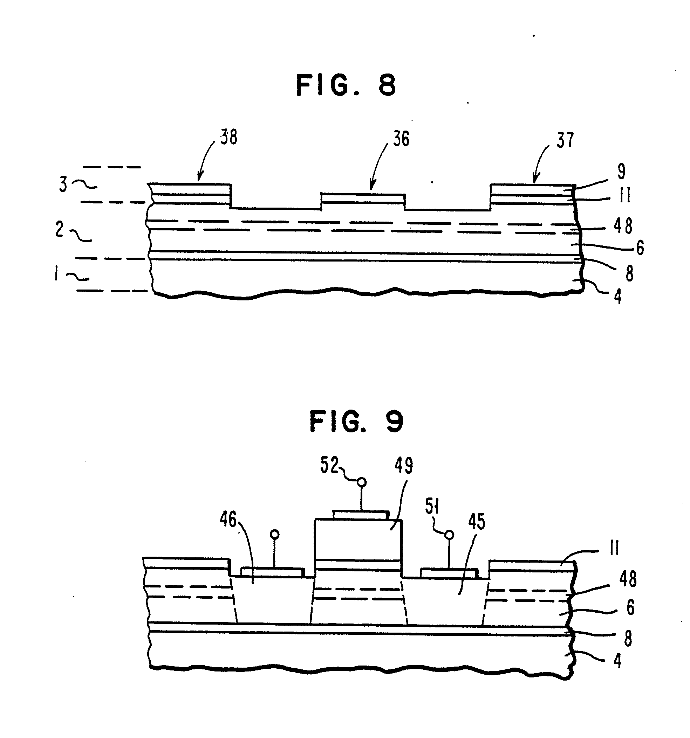

Referring to Fig. 8, included in the layer 6 as the structure is grown is an InGaAs channel region 48 which is achieved where the material of layer 6 is GaAs through the introduction of Indium along with the Gallium so that the material will be $Ga_{1-x}In_xAs$.

Further, in the device region 36, a portion of layer 9 has been removed so that layer 11 is exposed at location 36.

The layer 4 is of semi-insulating GaAs on which the layer 8 is an epitaxially molecular beam grown layer of AlGaAs approximately 100 Angstroms thick. The layer 6 for the devices is a 1 micron thick layer of GaAs in which the GaInAs layer 48 is of about 50 Angstroms in thickness positioned within conductor influencing distance to the region 36. The layer 11 is of AlGaAs about 0.1 micron in thickness and the layer 9 is of GaAs approximately 0.1 micron in thickness.

Referring next to Fig. 9, in the regions 45 and 46 the layer 6 has been eroded away and replaced with n+ conductivity type material which will serve as the source and drain electrodes of the field effect transistor in which the portion of the region 48 serves as the channel. A member 49 of GaAs is grown on the portion of layer 11 in the device region 36 to serve as the gate to the transistor and the remains of the layers 9 are removed from layer 11. Appropriate source and drain contacts 50 and 51 are applied to regions 46 and 45 respectively and an ohmic contact 52 for it to serve as a gate electrode is applied to the grown region 49.

The resulting device is a self-aligned GaAs gate field effect transistor (GaGFET) containing a strained layer InGaAs channel.

## Claims

1. An integrated circuit substrate product comprising in combination:
a member having an essentially planar surface area (15),
said member having a supporting region (1), and
serially respectively between said supporting region (1) and said surface (15),
a layer (2) of device quality monocrystalline material of a semiconductor having erosion termination capability (8) and being epitaxial with said supporting region (1),
a stop layer (11) of a monocrystalline material capable of terminating at least an erosion operation to which said semiconductor is responsive epitaxial with said device layer (2), and
an epitaxial regrowth enabling layer (9) of said semiconductor material epitaxial with said device layer (2) and including an epitaxial stop layer (14).

2. The product of claim 1 where said erosion termination capability is each provided by a layer (8, 11) of material with at least one of a different physical or chemical response property.

3. The product of claim 2 wherein the material of said erosion termination capability layer (8) and said stop layer (11) has a higher atom binding energy than said semiconductor material.

4. The product of claims 1 to 3 where said semiconductor material is of the compound semiconductor material type.

5. The product of claim 4 wherein said supporting region (1) is a high resistivity region of said compound semiconductor material.

6. The product of claims 2 to 5 wherein said compound semiconductor material is taken from the group of GaAs, InAs and the alloys thereof.

7. The product of claims 2 to 5 wherein said compound semiconductor is GaAs and the material of said erosion termination capability layer (8) and said stop layer is of $Ga_xAl_{1-x}As$.

8. The product of claims 1 to 7 where said epitaxial stop capability is a dielectric layer (14).

9. The process of fabricating an integrated circuit comprising in combination the steps of:

providing a compound semiconductor material substrate member having an essentially planar surface area (15),

said member having a supporting region (1),

serially respectively between said supporting region (1) and said surface (15),

a layer (2) of device quality monocrystalline material of said compound semiconductor having erosion termination capability (8) and being epitaxial with said supporting region (1),

a stop layer (11) of a monocrystalline material epitaxial with said device layer (2) and being capable of terminating at least an erosion operation to which said compound semiconductor is responsive,

an epitaxial regrowth enabling layer (9) of said compound semiconductor material epitaxial with said device layer (2) and including an stop layer, and a layer of a regrowth inhibiting layer (14),

removing in an opening pattern corresponding to device electrodes said regrowth inhibiting layer (14), said epitaxial regrowth enabling layer (9) and said stop layer (11),

eroding said device layer (2) through said opening pattern until said termination capability (8) of said device layer (2) is employed,

regrowing device material with selectable doping in said opening pattern,

removing polycrystalline regrown material, said regrowth inhibiting layer (14) and said regrowth enabling layer (9) from areas to serve as isolation,

remove polycrystalline regrown material and said regrowth inhibiting layer (14) from gate areas between device electrode areas in said pattern, and

applying ohmic contacts to the regrown material in the openings in said pattern and on said gate areas.

10. The process of claim 9 wherein said compound semiconductor is GaAs.

11. The process of claim 9 including a GaInAs channel region in said device layer (2) parallel to said stop layer (11).

# FIG. 1

# FIG. 2

# FIG. 3

# FIG. 4

## FIG. 5

## FIG. 6

## FIG. 7

# FIG. 8

# FIG. 9